# EUROPEAN PATENT SPECIFICATION

(11) **EP 2 475 964 B1**
(45) Date of publication and mention of the grant of the patent: **15.03.2017**
(21) Application number: 10765656.3
(22) Date of filing: 07.09.2010
(51) Int. Cl.: G01D 5/20, H03K 17/95, G01B 7/02

(54) **HIGH TEMPERATURE OPERATION INDUCTIVE POSITION SENSING DEVICE**
FÜR HOHE TEMPERATUREN GEEIGNETE INDUKTIVE POSITIONSMESSEINRICHTUNG
DISPOSITIF DE DÉTECTION DE POSITION PAR INDUCTION ADAPTÉ AUX TEMPÉRATURES ÉLEVÉES

(30) Priority: 08.09.2009 GB 0915670
(43) Date of publication of application: 18.07.2012
(73) Proprietor: Perception Sensors & Instrumentation Ltd, Doncaster DN5 7UP (GB)
(72) Inventor: HYDE, John, Doncaster DN5 7UP (GB)
(74) Representative: Vaughan, Christopher Tammo
(86) International application number: PCT/GB2010/051490
(87) International publication number: WO 2011/030142

(56) References cited:
- US-A- 3 183 126
- US-A- 3 308 411
- US-A- 3 336 525
- US-A- 3 484 678
- US-A- 5 789 918

## Description

This invention relates to a device for measuring relative positions and distances of metal objects in very high temperature environments, and can be used, for example, to measure air gaps between metal components in heat exchangers. It is desirable to make such air gaps as narrow as possible to increase heat transfer, while still taking into account significant physical distortions of the metal components due to thermal distortion as a result of large variations in temperature. Moreover, the metal components are often rotating, and can be up to 20m in diameter or more. A primary application of embodiments of the present invention is in power stations, but embodiments may also be useful for measuring the position of dampers in power station burners, or for determining positions of metal components in cement plants, steel works or any large combustion process where there are large movable metal components having a tendency to distort.

### BACKGROUND

It is often necessary to determine the distance or position of a metal object within harsh environments, such as heat exchanges, and several methods can be employed.

Optical systems measure the distance to the surface of the object by triangulation or laser time-of-flight. However these systems can be contaminated with dirt on the optical system or may make erroneous readings due to surface build-up of debris and corrosion. In high temperature applications the active optical components require mounting away from the measurement area and must be coupled with fibre optics or provided with cooling.

An alternative is the capacitive probe. The capacitance probe measures the capacitance between an end of the sensing probe and the target. This method is vulnerable to contaminations that are conductive in nature, such as water (condensate), and to some extent contamination on the surface of the target such as metal oxides. In general these devices are for short distance operation but can operate at high temperature.

A third method is the use of ultrasonic time of flight. However this is unsatisfactory at high gas temperatures due to the change in propagation time through air at different temperatures.

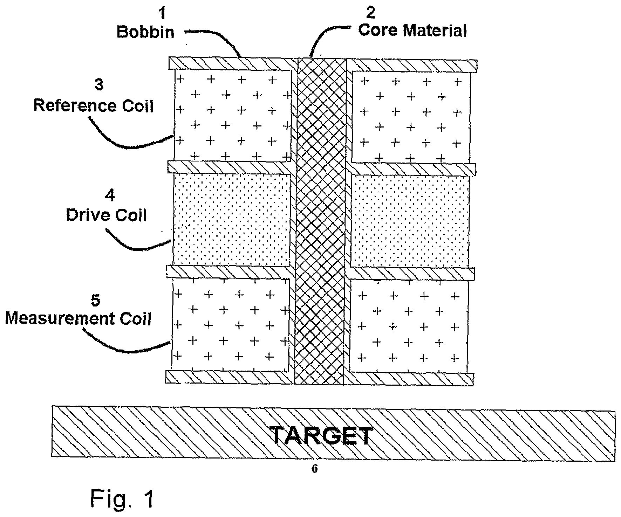

It is known to provide a positioning device such as that shown in Figure 1. The positioning device works on the basis of electromagnetic induction, and consists of a bobbin 1 generally formed from a plastic material which provides a low magnetic permeability former with high electrical resistance. The bobbin 1 provides a means for holding conductive windings 3, 4, 5 around a magnetic core 2. A distance of the device from a magnetically active target 6 can be determined in known manner by energizing the coils 3, 4, 5 and analyzing changes due to inductive effects as the magnetic field generated by the coils 3, 4, 5 and the core 2 interacts with the target 6. The upper temperature limit for plastics is generally quite low, with even high temperature plastics failing at around 220°C. The coils 3, 4, 5 are formed by winding polymer coated copper wire around the bobbin 1. This also has an upper temperature limit of around 200°C. The core 2 is typically formed using laminated electrical steels where the insulation between laminations is polymer-based. Due to the limitations of these materials the maximum operating temperature is around 200°C and in applications where the environment is above 200°C, additional cooling means, such as oil, water or air cooling manifolds, must be employed to prevent failure.

A typical such known device is, for example, available from Burmeister & Wain Energy A/S, and uses a sealed outer enclosure for the sensor so that a mineral oil coolant can be pumped through the sensor and out to a forced air cooling system. The main problem is that the cooling system is expensive, and if it fails, the sensor will also fail and the mineral oil will overheat. As the sensors are embedded deep inside the process, a failure of the cooling system will destroy the sensor, thus necessitating a total plant shutdown.

It is also known, for example from US3308411, US3484678, US3183126, US5789918 and US3336525, to provide a magnetic transducer that detects a distance travelled by a core that is moveably mounted within a set of coils. These devices are to be distinguished from the present invention, where the core is fixed relative to the coils, and the device is to sense a distance from the device of a metal target external to the device without making use of relative displacement between the core and the coils.

### BRIEF SUMMARY OF THE DISCLOSURE

According to a first aspect of the present invention, there is provided a position sensing device as set forth in claim 1 of the appended claims.

A particular advantage of embodiments of the present invention is that they avoid the use of plastics or polymers in their construction. This means that the device can be used at much higher temperatures, well in excess of 200°C, and with appropriate selection of components in excess of 300°C, 400°C or even 500°C, without the need for additional cooling means.

Embodiments of the present invention comprise metal and metal oxides components only. Some ceramics may be employed but are not essential. The resulting device can operate at elevated temperatures in high vibration environments without cooling.

Embodiments of the invention comprise three basic components: coils to generate and measure magnetic fields, a former or bobbin to hold the coils and a core to direct the magnetic field. For operation at e.g. 500°C without cooling, all the materials employed must withstand temperatures of 500°C.

In some embodiments, the discs or flanges form part of a bobbin structure also including a central cylindrical section that receives the core. In these embodiments, the discs or flanges and the central cylindrical section may be formed as a monolithic structure, or the discs or flanges may formed with a washer-like configuration and be welded or friction-fitted or otherwise securely mounted about the central cylindrical section.

The bobbin structure is required to withstand elevated temperatures for extended periods of time and must also have the capability of being cooled and reheated multiple times without the structural integrity being compromised. The bobbin structure is preferably of metal construction. The bobbin must have a relatively low magnetic permeability (with a relative permeability preferably no greater than 2, and in some embodiments no greater than 1.2), and austenitic steels or aluminium are both suitable materials. The lower the permeability of the metal employed, the higher the sensitivity of the device. Accordingly, a relative magnetic permeability close to one is most desirable for high sensitivity.

The bobbin structure may me formed from a single piece of metal with a central cylindrical hole, into which the core is inserted.

Alternatively, the bobbin is not constructed from a single piece of metal, rather it is made of several discs having a washer-like configuration which form spacers and end plates. These discs are attached onto the central cylindrical section, into which the core is inserted. The discs and the cylindrical section may be made from the same metal, or from different metals.

Alternatively, the discs may have a washer-like configuration and be welded or friction-fitted or otherwise securely mounted directly about the core. This construction is particularly advantageous in that it allows the conductive wires to be wound directly about the core thereby eliminating or at least reducing the low permeability gap that is introduced by the cylindrical central section of the bobbin described above.

The core is preferably a magnetic core having a permeability that is higher, preferably significantly higher, than that of the bobbin structure and/or the discs. The magnetic core may be a solid or a laminate core. A laminate core allows a higher operating frequency due to the reduction in eddy current losses but is a more complex assembly than a simple solid core. The use of a solid core provides optimal strength to the device but limits the maximum operating frequency to a few hundred hertz. As the core must have the ability to withstand high temperatures whilst maintaining its magnetic properties, the core material preferably has a Curie point in excess of the maximum intended operating temperature of the device. Where laminate material is used, this is preferably a high temperature annealed type laminate material. As the sensitivity of the sensor device is affected by the magnetic permeability of the core (with a high permeability giving the highest sensitivity), the core material preferably has a high permeability. In some embodiments, the relative permeability of the magnetic core is greater than 100, or greater than 500.

However cores with a permeability of one or close to one can be used where low sensitivities can be accepted. This allows air or non-magnetic materials to be used as the core material.

In embodiments where the discs are mounted directly on the core, the core may be made of a first metal with a relatively high magnetic permeability (for example greater than 100 or greater than 500), and the discs may be made of a second metal with a relatively low magnetic permeability (typically no greater than 2, or no greater than 1.2). Different types of steel may be used and welded together to form a combined bobbin and core of extremely robust construction that can be used in operating temperatures in excess of 700°C.

In some embodiments, at least one of the discs or flanges may include a radial slot to allow the conductive winding wire to be fed away from the assembly in a convenient manner. The radial slot breaks the circular conductive path around the coil assembly which would otherwise act as a single shorted turn around the core and thereby reduce the overall efficiency. In this way, the radial slot can reduce eddy currents within the discs to provide more efficient and stable operation.

Instead of a radial slot, appropriately-placed holes may be provided to allow the conductive winding wire to be fed away from the assembly.

The coil windings may be made with anodised aluminium wire. In some embodiments, the wire may be around 0.5mm in diameter, although other diameters may be used where appropriate. Such aluminium wire typically has a usable temperature range up to 500°C. Above this temperature softening of the wire may occur with a corresponding loss in reliability.

The aluminium oxide layer formed by the anodising process produces an insulation layer around the wire. The insulation layer has excellent dielectric properties and is stable up to 2000°C. As the insulation is an oxide of the aluminium, the insulating layer surrounding the conducting section of the wire improves with operation at elevated temperature when exposed to air or other similar oxygen rich atmospheres. Some self healing will also occur should the insulating layer be damaged. The coil windings wound on the bobbin or former, or directly onto the core, form a coil assembly capable of operating continuously and without cooling at very high temperatures.

Other types of wire include ceramic-coated wires, including ceramic-coated copper wire such as that available from Ceramawire®.

Many different coil arrangements and topologies may be utilized with the present invention.

The coil at a top end of the bobbin may be configured as the reference coil, a coil at a bottom end of the bobbin may be configured as the detection or measurement coil, and an intermediate coil may be configured as the drive coil.

In each case, what is important is the provision of a metal bobbin and high-temperature wire, both of which allow use at elevated temperatures without the use of coolants.

### BRIEF DESCRIPTION OF THE DRAWINGS

Embodiments of the invention are further described hereinafter with reference to the accompanying drawings, in which:
Figure 1 shows a cross-section of a prior art position sensing device with polymeric components;
Figure 2 shows a cross-section of a first embodiment of the present invention;
Figure 3 shows a cross-section of a second embodiment of the present invention;
Figure 4 shows a view of the underside of the embodiment of Figure 3;
Figure 5 illustrates a circulating current in a conducting disc;
Figure 6 is a circuit diagram illustrating the use of a two-coil arrangement not being part of the present invention;
Figure 7 is a circuit diagram illustrating the use of a three-coil embodiment of the present invention;
Figure 8 illustrates the use of a reference target with an embodiment of the present invention; and
Figure 9 illustrates a full implementation of a position sensing system employing an embodiment of the present invention.

### DETAILED DESCRIPTION

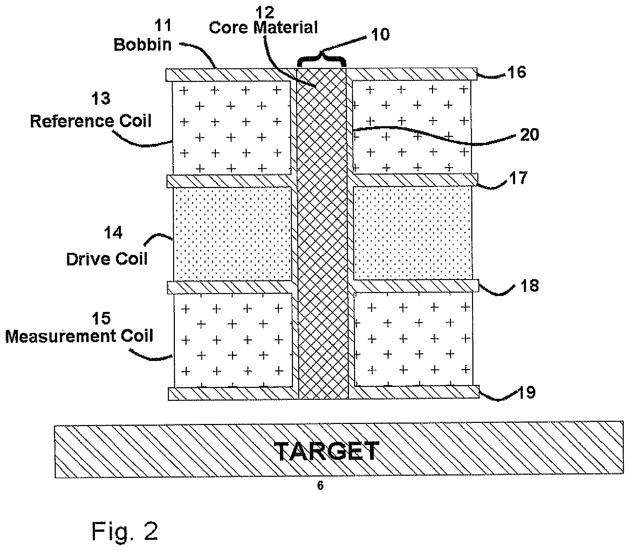

A first embodiment of the invention, comprising three coils, is shown in Figure 2. The general structure is similar to that of the device of Figure 1, comprising a bobbin 11 and conductive windings or coils 13 (reference coil), 14 (drive coil), 15 (measurement or sensing coil) around a cylindrical magnetic core 12. In contrast to the prior art device of Figure 1, the bobbin 11 of Figure 2 is constructed from a single piece of metal with a central hole 10, through which a solid or laminate magnetic core 12 is inserted. A laminate core 12 allows a higher operating frequency due to the reduction in eddy current losses but is a more complex assembly than a simple solid core. The use of a solid core 12 provides optimal strength to the sensor but limits the maximum operating frequency to a few hundred hertz. As the core 12 must have the ability to withstand high temperatures whilst maintaining its magnetic properties, the core material must have a Curie point in excess of the maximum operating temperature of the sensor. Where laminate material is used this should be of the high temperature annealed type.

The bobbin 11 comprises a hollow cylindrical section 20 defining the central hole 10, and flanges 16, 17, 18 and 19 which act as end plates and spacer plates to separate the coils 13, 14, 15.

The coil windings 13, 14, 14 are made with anodised aluminium wire typically 0.5mm diameter. The aluminium wire has a usable temperature range up to 500°C. The aluminium oxide layer formed by the anodising process produces an insulation layer around the wire. The insulation layer has excellent dielectric properties and is stable up to 2000°C. As the insulation is an oxide of the aluminium the insulating layer surrounding the conducting section of the wire improves with operation at elevated temperature when exposed to air or other similar oxygen rich atmospheres. Some self healing will also occur should the insulating layer be damaged. The coil windings 13, 14, 15 wound on the metal coil former 20 form a coil assembly capable of operating at temperatures up to 500°C continuously and without cooling. The construction is shock and vibration resistant allowing the device to be installed in extremely harsh environment.

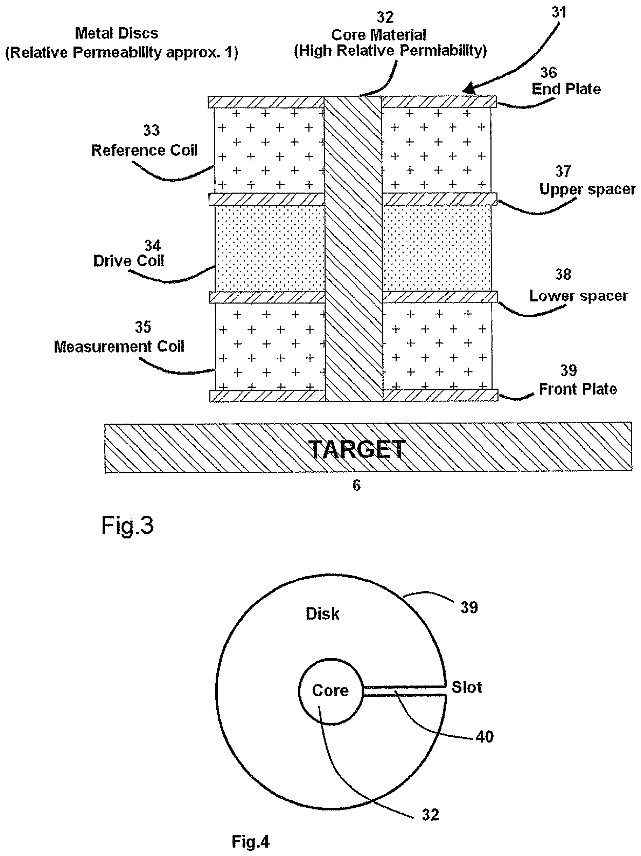

In the embodiment of the invention shown in Figure 3, the bobbin 31 is not constructed from a single piece of metal, rather it is made of several discs 36, 37, 38, 39 which form the spacers and end plates. These plates are then attached onto a central cylinder 32. This cylinder 32 can either be a hollow holder for the full core as in the design shown in Figure 2, or the central cylinder 32 may be the core itself with the discs 36, 37, 38, 39 attached directly to it as shown. For example in this embodiment two variants of steel may be employed, one of high permeability for the central core 32, the other of low permeability for the discs 36-39. Then the two different steels are welded together to form a combined bobbin and core. This configuration provides a simple solid construction where the coil windings 33 (reference coil), 34 (drive coil), 35 (measurement coil) are wound directly onto the high permeability core 11 eliminating the low permeability gap between windings and core seen in the embodiment of Figure 2. The resulting construction is highly robust, with the bobbin 31 being able to withstand temperatures in excess of 700°C.

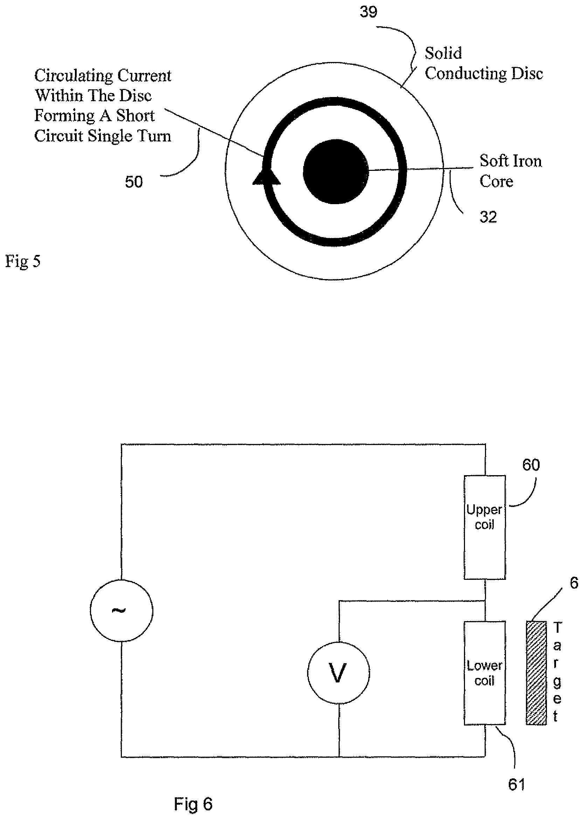

Figure 4 shows a slot 40 incorporated in the front plate 39 (a similar slot may be incorporated in the end plate 36) to allow the winding wire to be fed away from the coil assembly in a convenient manner. The slot 40 is optional and can be replaced by small appropriately placed holes. However the slot 40 also breaks the circular conductive path 50 around the coil assembly shown schematically in Figure 5, where the slot 40 is absent. This circular conductive path 50 behaves like a shorted single turn around the core 32 and reduces the overall efficiency of the system. The slot 40 therefore reduces eddy current losses within the former plates 36-39 providing more efficient and stable operation.

Figure 5 shows that a stainless steel disc 39 can be viewed as a short circuit turn 50 and will therefore have circulating currents present. Whilst this reduces the efficiency of the system there is little affect on overall sensitivity.

In the embodiment in Figure 3, the core 32 may be a solid carbon steel core. This reduces the maximum operating frequency of the measuring system due to induced circulating currents. However, at relatively low frequencies and drive currents these circulating currents are low and the system operates satisfactory. For higher frequency operation a laminated core can be employed but this can no longer be fabricated in the simple welded construction possible with other embodiments. Also as the system employs solid conductive materials the induced electromotive forces must be kept low. This is achieved by employing low excitation currents. Circulating currents are also minimised by employing grades of steel with relatively high resistivity.

The resulting coil former is an extremely robust design resistant to high temperatures and mechanical shock. The core is able to operate satisfactorily up to the Curie point of the core material and is typically over 700°C.

### Coil configurations

Figure 6 shows two coil operation employing upper and lower coil sections 60, 61 only and is configured as a standard potential divider sensor. In this configuration with no target 6 present, the drive voltage is divided by the ratio of the impedance of the upper and lower coils 60, 61. As the lower coil 61 impedance changes due to the proximity of the target 6, the voltage V changes as a function of the target distance from the measuring coil. This is not part of the present invention.

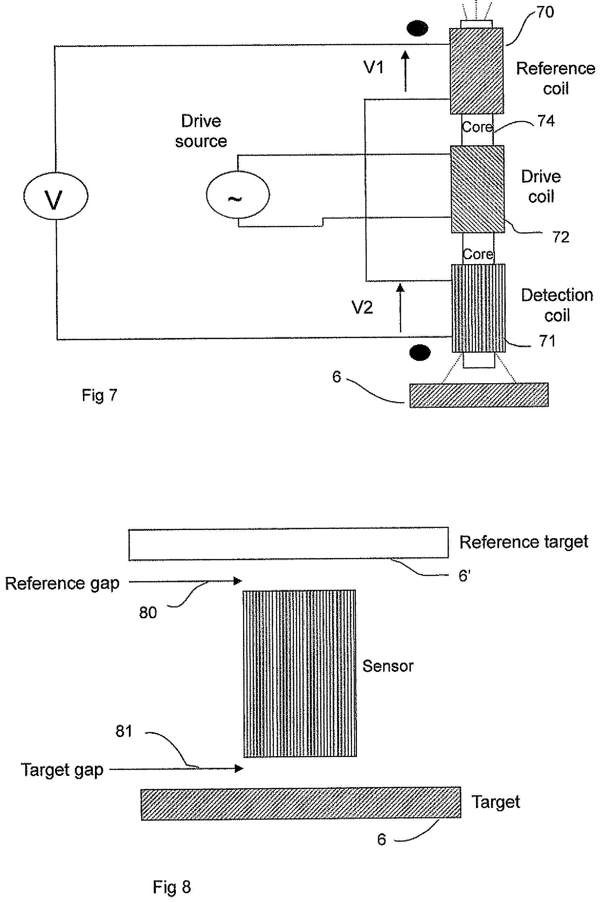

Figure 7 shows the system in three coil operation. In this configuration a drive coil 72 establishes a magnetic field within the coil assembly and magnetic core 74 extending into the immediate surroundings. In the absence of a target 6, the system is symmetrical and balanced such that the reference coil 70 and the detection coil 71 detect the generated magnetic field equally. The resulting differential voltage between the reference coil 70 and the detection coil 71 is very low and is due only to imbalances in the manufacturing of the reference and detection coils 70, 71. When a target 6 is in proximity to the detection coil 71, the magnetic field becomes unbalanced and the resulting differential voltage increases. The magnitude of the voltage is therefore a function of the distance of the target 6 to the detection coil 71.

### Temperature effects

The magnetic susceptibility and the resistivity of target steels such as carbon steel changes with temperature. This changes the relationship between distance and voltage output as a function of temperature. In practice the temperature of the system should be measured and appropriate temperature compensation applied. If the detection system is based on a fixed operating point where the distance is to be controlled at a specific distance, a reference target 6' can be introduced, in addition to the actual target 6, as in Figure 7.

When employed with the three coil system the reference target 6' is of the same material as the target 6 and the reference gap 80 is the same as the target gap 81 to be measured. This results in the system being balanced with the same voltage on both the reference and sensing coils. This balance will remain virtually independent of temperature, and provided the difference between the two coils is measured then essentially a zero output will result over a very wide temperature range. Changes in output will result from variations in symmetry so the construction should be as symmetrical as possible. Deviation from the set point by changes in distance of the target 6 will result in the sensing voltage becoming larger than the reference voltage for shorter distances and vice-versa. The magnitude of the voltage is a function of distance whilst the phase with respect to the drive voltage gives an indication of direction.

Temperature will affect the sensitivity when away from balance due to the change in resistance of the drive coil, the permeability of the soft iron components and the change in the resistivity of the metallic components including bobbins, formers and target. In conventional measuring systems the armature is placed centrally in the coil and its deviation from the centre increases the output from one coil and a corresponding decrease in the other. This allows the use of the technique published by Analog Devices where the position is given by *(V1+V2)*/*(V1-V2).* In this configuration virtually all errors cancel as the output is effectively normalised against the total magnetic field produced by the drive coil. This topology can be used by an embodiment of this invention where the armature is a free moving component replacing the fixed solid core of the first embodiment.

For distance measurement where the target is external to and not connected to the measuring coil, the error cancellation based on *(V1+V2)l(V1-V2)* does not work as the total output changes with target position. In the configuration shown in Figure 8, the output of the coil when not at balance changes with temperature due to several factors described previously. As these factors are a function of the properties of the material used in the construction and their corresponding temperature, temperature compensation is possible based on the measurement of the coil assembly temperature and the target temperature. Where possible the coil assembly temperature, target temperature and reference target temperature should be the same. In this instance a single temperature correction can be made. Where this is not practical three temperatures should be used, target, coil assembly, and reference. Individual compensations can then be made for each of the components.

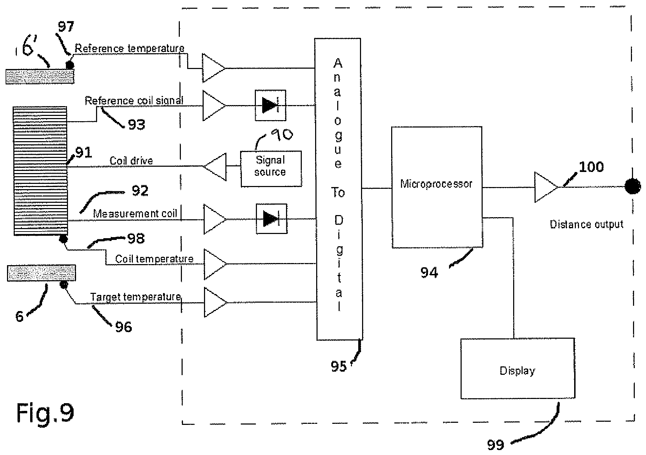

A typical implementation of the full measuring system is shown in Figure 9, where a sinusoidal drive signal 90 excites the drive coil 91. Measurements of the sensing 92 and reference 93 coil voltages are made such that either the difference only is measured or the individual coil voltages are measured so that sum and differences can be calculated within a microcontroller or microprocessor 94. The AC signals are rectified either in hardware or software if the analog-to-digital conversion rate is sufficiently high in analog-to-digital converter 95. Temperature measurements are made of either the coil body 98 or coil body 98, reference 97 and target 96 temperatures. As the relationship between target 6 distance and signal voltage is highly non-linear the microcontroller/microprocessor 94 provides linearization functions such that the system output is proportional to the distance between target 6 and coil. The microcontroller/microprocessor 94 also measures the appropriate temperatures and applies temperature compensation algorithms to minimise temperature effects on the overall measurement. The microcontroller/microprocessor 94 then provides suitable output means by way of display 99, analogue outputs 100 or alarm functions as per the system requirements.

Throughout the description and claims of this specification, the words "comprise" and "contain" and variations of them mean "including but not limited to", and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

## Claims

1. A position sensing device comprising:
i) a cylindrical core (12, 32, 74) having a longitudinal axis, a first end, a second end and a middle portion between the first end and the second end;
ii) conductive wire coil windings (13-15, 33-35, 60-61, 70-72) around the longitudinal axis to define a first drive coil (14, 34, 60, 72) around the middle portion of the cylindrical core (12, 32, 74), a reference coil (13, 33, 60, 70) around the first end of the cylindrical core (12, 32, 74) and a measurement coil (15, 35 ,61, 71) around the second end of the cylindrical core (12, 32, 74);
wherein the reference coil (13, 33, 60, 70) is wound between a first pair of discs or flanges (16, 17; 31, 37) mounted about the longitudinal axis and the measurement coil (15, 35 ,61, 71) is wound between a second pair of discs or flanges (18, 19; 38, 39) mounted about the longitudinal axis;
wherein the core (12, 32, 74) and the discs or flanges (16-19, 36-39) are in a mutually spatially fixed relationship;
**characterized in that** the conductive wire of each coil winding (13-15, 33-35, 60-61, 70-72) comprises a conductive metal with a substantially dielectric oxide or ceramic coating, and wherein the discs or flanges (16-19,36-39) are made of non-polymeric material; and
**in that** the position sensing device further comprises a reference target (6') located at the first end of the cylindrical core (12, 32, 74) so as to define a reference gap (80) of predetermined size between the reference target (6') and the first end of the cylindrical core (12, 32, 74);
such that a potential difference between the potentials induced by the drive coil (14, 34, 60, 72) in the reference coil (13, 33, 60, 70) and the measurement coil (15, 35 ,61, 71) is substantially zero when a metal target (6) external to the device, and made of the same material as the reference target (6'), is spaced from the second end of the cylindrical core (12, 32, 74) by a distance equal (81) to the size of the reference gap (80).

2. A device as claimed in claim 1, wherein the conductive wire is anodised aluminium wire with a substantially dielectric aluminium oxide coating.

3. A device as claimed in claim 1 or 2, wherein the discs or flanges (16-19) form part of a bobbin structure (11) also including a hollow central cylindrical section (20) that defines or receives the cylindrical core (12).

4. A device as claimed in claim 3, wherein at least one of the discs or flanges (16-19) and the central cylindrical section (20) form a monolithic structure.

5. A device as claimed in claim 3 or 4, wherein at least one of the discs or flanges (16-19) is welded or attached to the central cylindrical section (20).

6. A device as claimed in claim 1 or 2, wherein the cylindrical core (32) is made of a metal material and wherein the discs or flanges (36-39) are directly welded or attached to the cylindrical core (32).

7. A device as claimed in claim 3 or 6, or claim 5 depending from claim 3, wherein at least one of the discs or flanges (16-19, 36-39) is made of a first material and the cylindrical core (12, 32) is made of a second material.

8. A device as claimed in claim 7, wherein the first and second materials are the same or different.

9. A device as claimed in any preceding claim, wherein the discs or flanges (16-19, 36-39) are made of a material with a relative magnetic permeability not greater than 2.

10. A device as claimed in any preceding claim, wherein the cylindrical core (12, 32, 74) is a magnetic metal core; optionally having a relative magnetic permeability greater than 100.

11. A device as claimed claim 10, wherein the cylindrical core (12, 32, 74) is a solid core or a laminate core.

12. A device as claimed in any one of claims 1 to 9, wherein the cylindrical core (12, 32, 74) is an air core or a non-metallic core.

13. A device as claimed in any preceding claim, wherein at least one disc or flange (39) includes a radial slot (40).

## Patentansprüche

1. Positionserkennungsvorrichtung, umfassend:
i) einen zylindrischen Kern (12, 32, 74) mit einer Längsachse, einem ersten Ende, einem zweiten Ende und einem Mittelabschnitt zwischen dem ersten Ende und dem zweiten Ende;
ii) leitfähige Drahtspulenwicklungen (13-15, 33-35, 60-61, 70-72) um die Längsachse, um eine erste Antriebsspule (14, 34, 60, 72) um den Mittelabschnitt des zylindrischen Kerns (12, 32, 74), eine Referenzspule (13, 33, 60,70) um das erste Ende des zylindrischen Kerns (12, 32, 74) und eine Messspule (15, 35, 61, 71) um das zweite Ende des zylindrischen Kerns (12, 32, 74) zu definieren;
wobei die Referenzspule (13, 33, 60, 70) zwischen einem ersten Paar an Scheiben oder Flanschen (16, 17; 31, 37) gewickelt ist, das um die Längsache angebracht ist und die Messspule (15, 35 ,61, 71) zwischen einem zweiten Paar an Scheiben oder Flanschen (18, 19; 38, 39) gewickelt ist, das um die Längsachse angebracht ist;
wobei der Kern (12, 32, 74) und die Scheiben oder Flansche (16-19, 36-39) in einer gegenseitig räumlich festen Beziehung sind;
**dadurch gekennzeichnet, dass** der leitfähige Draht jeder Spulenwicklung (13-15, 33-35, 60-61, 70-72) ein leitfähiges Metall mit einer im Wesentlichen dielektrischen Oxid- oder Keramikbeschichtung umfasst und wobei die Scheiben oder Flansche (16-19, 36-39) aus einem nichtpolymerischen Material gefertigt sind; und
dadurch, dass die Positionserkennungsvorrichtung weiter ein Referenzziel (6') umfasst, das sich an dem ersten Ende des zylindrischen Kerns (12, 32, 74) befindet, um eine Referenzlücke (80) von zuvor festgelegter Größe zwischen dem Referenzziel (6') und dem ersten Ende des zylindrischen Kerns (12, 32, 74) zu definieren;
sodass eine Potentialdifferenz zwischen den durch die Antriebsspule (14, 34, 60, 72) in der Referenzspule (13, 33, 60, 70) und der Messspule (15, 35 ,61, 71) induzierten Potentialen im Wesentlichen Null ist, wenn ein Metallziel (6) außerhalb der Vorrichtung und aus dem gleichen Material wie das Referenzziel (6') gefertigt von dem zweiten Ende des zylindrischen Kerns (12, 32, 74) um einen Abstand gleich (81) der Größe der Referenzlücke (80) beabstandet ist.

2. Vorrichtung nach Anspruch 1, wobei der leitfähige Draht anodisierter Aluminiumdraht mit einer im Wesentlichen dielektrischen Aluminiumoxidbeschichtung ist.

3. Vorrichtung nach Anspruch 1 oder 2, wobei die Scheiben oder Flansche (16-19) Teil einer Bobinenstruktur (11) bilden, die auch einen hohlen mittigen zylindrischen Abschnitt (20) beinhaltet, der den zylindrischen Kern (12) definiert oder aufnimmt.

4. Vorrichtung nach Anspruch 3, wobei mindestens eine(r) der Scheiben oder Flansche (16-19) und der mittige zylindrische Abschnitt (20) eine monolithische Struktur bilden.

5. Vorrichtung nach Anspruch 3 oder 4, wobei mindestens eine(r) der Scheiben oder Flansche (16-19) an den mittigen zylindrischen Abschnitt (20) geschweißt oder angebracht ist.

6. Vorrichtung nach Anspruch 1 oder 2, wobei der zylindrische Kern (32) aus einem Metallmaterial gefertigt ist und wobei die Scheiben oder Flansche (36-39) direkt an den zylindrischen Kern (32) geschweißt oder angebracht sind.

7. Vorrichtung nach Anspruch 3 oder 6 oder Anspruch 5 abhängig von Anspruch 3, wobei mindestens eine(r) der Scheiben oder Flansche (16-19, 36-39) aus einem ersten Material gefertigt ist und der zylindrische Kern (12, 32) aus einem zweiten Material gefertigt ist.

8. Vorrichtung nach Anspruch 7, wobei das erste und zweite Material gleich oder unterschiedlich sind.

9. Vorrichtung nach einem vorhergehenden Anspruch, wobei die Scheiben oder Flansche (16-19, 36-39) aus einem Material mit einer relativ magnetischen Permeabilität, die nicht größer als 2 ist, gefertigt sind.

10. Vorrichtung nach einem vorhergehenden Anspruch, wobei der zylindrische Kern (12, 32, 74) ein magnetischer Metallkern ist; optional eine relativ magnetische Permeabilität, die größer als 100 ist, aufweisend.

11. Vorrichtung nach Anspruch 10, wobei der zylindrische Kern (12, 32, 74) ein fester Kern oder ein Laminatkern ist.

12. Vorrichtung nach einem der Ansprüche 1 bis 9, wobei der zylindrische Kern (12, 32, 74) ein Luftkern oder ein nichtmetallischer Kern ist.

13. Vorrichtung nach einem vorhergehenden Anspruch, wobei mindestens ein(e) Scheibe oder Flansch (39) einen radialen Schlitz (40) beinhaltet.

## Revendications

1. Dispositif de détection de position, comprenant :
i) un noyau cylindrique (12, 32, 74) présentant un axe longitudinal, un premier bout, un deuxième bout, et une partie intermédiaire entre le premier bout et le deuxième bout ;
ii) des enroulements en bobine de fil conducteur (13-15, 33-35, 60-61, 70-72) autour de l'axe longitudinal, pour définir une première bobine d'excitation (14, 34, 60, 72) autour de la partie intermédiaire du noyau cylindrique (12, 32, 74), une bobine de référence (13, 33, 60, 70) autour du premier bout du noyau cylindrique (12, 32, 74), et une bobine de mesure (15, 35, 61, 71) autour du deuxième bout du noyau cylindrique (12, 32, 74) ;
la bobine de référence (13, 33, 60, 70) étant enroulée entre une première paire de disques ou de flasques (16, 17; 31, 37) montée sur l'axe longitudinal, et la bobine de mesure (15, 35, 61, 71) étant enroulée entre une deuxième paire de disques ou de flasques (18, 19 ; 38, 39) montée sur l'axe longitudinal ;
le noyau (12, 32, 74) et les disques ou flasques (16-19, 36-39) étant espacés fixement l'un par rapport à l'autre ;
**caractérisé en ce que** le fil conducteur de chaque enroulement de bobine (13-15, 33-35, 60-61, 70-72) comprend un métal conducteur recouvert d'un revêtement en oxyde ou en céramique substantiellement diélectrique, et les disques ou flasques (16-19, 36-39) sont réalisés avec un matériau non polymérique ; et
**en ce que** le dispositif de détection de position comprend en outre une cible de référence (6') située sur au premier bout du noyau cylindrique (12, 32, 74), de façon à définir un écart de référence (80) d'une taille prédéterminée entre la cible de référence (6') et le premier bout du noyau cylindrique (12, 32, 74) ;
de sorte qu'une différence de potentiel entre les potentiels induits par la bobine d'excitation (14, 34, 60, 72) dans la bobine de référence (13, 33, 60, 70) et la bobine de mesure (15, 35, 61, 71) est substantiellement nulle lorsqu'une cible métallique (6) extérieure au dispositif, et réalisée avec le même matériau que la cible de référence (6'), est espacée du deuxième bout du noyau cylindrique (12, 32, 74) d'une distance égale (81) à la taille de l'écart de référence (80).

2. Dispositif selon la revendication 1, le fil conducteur étant un fil d'aluminium anodisé comprenant un revêtement d'oxyde d'aluminium substantiellement diélectrique.

3. Dispositif selon la revendication 1 ou 2, les disques ou flasques (16-19) faisant partie d'une structure à bobine (11), et comprenant également une section cylindrique centrale creuse (20) définissant ou recevant le noyau cylindrique (12).

4. Dispositif selon la revendication 3, au moins un des disques ou flasques (16-19) et la section cylindrique centrale creuse (20) forment une structure monolithique.

5. Dispositif selon la revendication 3 ou 4, au moins un des disques ou flasques (16-19) étant soudé ou fixé sur la section cylindrique centrale (20).

6. Dispositif selon la revendication 1 ou 2, le noyau cylindrique (32) étant réalisé avec un matériau métallique, et les disques ou flasques (36-39) étant soudés ou fixés directement sur le noyau cylindrique (32).

7. Dispositif selon la revendication 3 ou 6, ou la revendication 5 en fonction de la revendication 3, au moins un des disques ou flasques (16-19, 36-39) étant réalisés avec un premier matériau, et le noyau cylindrique (12, 32) étant réalisé avec un deuxième matériau.

8. Dispositif selon la revendication 7, le premier et le deuxième matériaux étant les mêmes ou différents.

9. Dispositif selon une quelconque des revendications précédentes, les disques ou flasques (16-19, 36-39) étant réalisés avec un matériau présentant une perméabilité magnétique relative ne dépassant pas 2.

10. Dispositif selon une quelconque des revendications précédentes, le noyau cylindrique (12, 32, 74) étant un noyau métallique magnétique, présentant en option une perméabilité magnétique relative supérieure à 100.

11. Dispositif selon la revendication 10, le noyau cylindrique (12, 32, 74) étant un noyau plein ou un noyau stratifié.

12. Dispositif selon une quelconque des revendications 1 à 9, le noyau cylindrique (12, 32, 74) étant un noyau d'air ou un noyau non métallique.

13. Dispositif selon une quelconque des revendications précédentes, au moins un disque ou flasque (39) présentant une fente radiale (40).
